# EUROPÄISCHE PATENTSCHRIFT

(11) **EP 4 226 099 B1**
(45) Veröffentlichungstag und Bekanntmachung des Hinweises auf die Patenterteilung: **27.05.2026**
(21) Anmeldenummer: 21801412.4
(22) Anmeldetag: 05.10.2021
(51) Int. Cl.: F25B 13/00, F25B 41/385, F25B 49/02, F25B 41/39

(54) **KÄLTEKREISLAUFVORRICHTUNG UND VERFAHREN ZUM BETRIEB EINER SOLCHEN KÄLTEKREISLAUFVORRICHTUNG**
REFRIGERATION CIRCUIT DEVICE, AND METHOD FOR OPERATING A REFRIGERATION CIRCUIT DEVICE OF THIS TYPE
DISPOSITIF DE CIRCUIT DE RÉFRIGÉRATION, ET PROCÉDÉ POUR FAIRE FONCTIONNER UN TEL DISPOSITIF DE CIRCUIT DE RÉFRIGÉRATION

(30) Priorität: 09.10.2020 DE 102020126580
(43) Veröffentlichungstag der Anmeldung: 16.08.2023
(73) Patentinhaber: Viessmann Holding International GmbH, 35108 Allendorf (Eder) (DE)
(72) Erfinder: HAFNER, Ulrich, 35099 Burgwald (DE); WREDE, Christopher, 59964 Medebach (DE)
(74) Vertreter: Wolf & Wolf Patentanwaltsgesellschaft mbH
(86) Internationale Anmeldenummer: PCT/DE2021/100798
(87) Internationale Veröffentlichungsnummer: WO 2022/073555

(56) Entgegenhaltungen:
- DE-T5- 112015 003 005
- US-A1- 2006 080 989
- US-A1- 2019 257 562

## Beschreibung

Die Erfindung betrifft eine Kältekreislaufvorrichtung gemäß dem Oberbegriff des Patentanspruchs 1 und ein Verfahren zum Betrieb einer solchen Kältekreislaufvorrichtung gemäß dem Patentanspruch 7.

Eine Kältekreislaufvorrichtung der eingangs genannten Art ist aus dem Dokument EP 2 083 229 B1 bekannt. Diese besteht aus einem Verdichter zur Kompression eines Kältemittels, wobei - jeweils in Strömungsrichtung des Kältemittels gesehen - dem Verdichter ein Kondensator, dem Kondensator eine erste Expansionseinrichtung, der ersten Expansionseinrichtung ein Wärmeübertrager, dem Wärmeübertrager eine zweite Expansionseinrichtung, der zweiten Expansionseinrichtung ein Verdampfer und dem Verdampfer im weiteren Verlauf der Verdichter nachgeschaltet ist, wobei der Wärmeübertrager mit einer zu kühlenden, elektronischen Einrichtung verbunden ausgebildet ist. Bei dieser Lösung ist die erste Expansionseinrichtung als feststehende Drossel und die zweite Expansionseinrichtung als variable Drossel ausgebildet. Die Maßgabe "im weiteren Verlauf" bedeutet dabei (und zwar auch im Folgenden), dass der Verdampfer wahlweise direkt oder aber auch unter Zwischenschaltung einer oder mehrerer Komponenten wie zum Beispiel eines Flüssigkeitsabscheiders mit dem Verdichter verbunden ausgebildet ist.

Der Erfindung liegt die Aufgabe zugrunde, eine Kältekreislaufvorrichtung der eingangs genannten Art sowie das Verfahren zu ihrem Betrieb zu verbessern. Insbesondere soll eine Kältekreislaufvorrichtung geschaffen werden, bei der auch Einfluss auf die sogenannte Sauggastemperatur, also auf die Temperatur des vom Verdichter angesaugten Kältemittels, genommen werden kann.

Diese Aufgabe ist gegenständlich mit einer Kältekreislaufvorrichtung der eingangs genannten Art durch die im Kennzeichen des Patentanspruchs 1 aufgeführten Merkmale gelöst. Die verfahrenstechnischen Merkmale zur Lösung dieser Aufgabe sind im Patentanspruch 7 aufgeführt.

Nach der Erfindung ist gegenständlich also vorgesehen, dass der Wärmeübertrager zur zusätzlichen Übertragung von Wärme auf das Kältemittel als innerer Wärmeübertrager ausgebildet ist und eine einerseits mit der ersten und andererseits mit der zweiten Expansionseinrichtung verbundene Primärseite und eine einerseits mit dem Verdampfer und andererseits mit dem Verdichter verbundene Sekundärseite aufweist. Verfahrenstechnisch ausgedrückt, ist vorgesehen, dass wahlweise mittels der ersten und/oder zweiten Expansionseinrichtung die Temperatur der elektronischen Einrichtung, vorzugsweise ein Frequenzumrichter, geregelt wird. Diese Maßgaben gewährleisten dabei, dass der Taupunkt an der elektronischen Einrichtung nicht unterschritten und die maximal zulässige Temperatur der elektronischen Einrichtung nicht überschritten wird.

Mit anderen Worten zeichnet sich die erfindungsgemäße Kältekreislaufvorrichtung somit dadurch aus, dass der als sogenannter "innere Wärmeübertrager" ausgebildete Wärmeübertrager nunmehr gleichzeitig sowohl mit der zu kühlenden, elektronischen Einrichtung als auch mit dem vom Verdampfer zum Verdichter strömenden Kältemittel wärmetauschend ausgebildet ist. Unter einem "inneren Wärmeübertrager" ist dabei genauer betrachtet entsprechend ein solcher Wärmeübertrager zu verstehen, bei dem zur Sauggastemperaturregelung Energie vom kondensierten Kältemittel (Kältemittelkondensat) auf das vom Verdichter angesaugte Kältemittel (Sauggas) übertragen wird.

Andere vorteilhafte Weiterbildungen der erfindungsgemäßen Kältekreislaufvorrichtung sowie des Verfahrens zu deren Betrieb ergeben sich aus den abhängigen Patentansprüchen.

Der Vollständigkeit halber wird noch auf das Dokument DE 11 2015 003 005 T5 hingewiesen. Das Dokument D1=DE 11 2015 003005 T5 offenbart eine Kältekreislaufvorrichtung mit den Merkmalen gemäß dem Oberbegriff von Anspruch 1.

Bei dieser Lösung fehlt allerdings am inneren Wärmeübertrager die zu kühlende, elektronische Einrichtung; dabei wird an dieser Stelle außerdem darauf hingewiesen, dass aufgrund der sich damit absehbar ergebenden hohen Komplexität der Regelung diese Lösung den Fachmann gerade nicht dazu anregen würde, am inneren Wärmeübertrager eine zu kühlende, elektronische Einrichtung anzuordnen.

Ferner wird noch auf die Dokumente US 2006/0080989 A1, DE 102 39 877 A1, JP H02-73562 U und US 2019/0257562 A1 hingewiesen.

Gemäß der vorliegenden Erfindung wird das oben genannte Ziel durch die Merkmale von Anspruch 1 und Anspruch 7 gelöst. Bevorzugte Ausführungsformen sind in den abhängigen Ansprüchen definiert.

Die erfindungsgemäße Kältekreislaufvorrichtung einschließlich ihrer vorteilhaften Weiterbildungen gemäß der abhängigen Patentansprüche wird nachfolgend anhand der zeichnerischen Darstellung verschiedener Ausführungsbeispiele näher erläutert.

Es zeigt schematisch
- Figur 1: eine erste Ausführungsform der erfindungsgemäßen Kältekreislaufvorrichtung mit regelbaren Expansionseinrichtungen;
- Figur 2: teilweise eine zweite Ausführungsform der erfindungsgemäßen Kältekreislaufvorrichtung mit einer Zusatz-Expansionseinrichtung; und
- Figur 3: teilweise eine dritte Ausführungsform der erfindungsgemäßen Kältekreislaufvorrichtung mit einer nicht-regelbaren bzw. feststehenden zweiten Expansionseinrichtung.

Die in den Figuren dargestellte Kältekreislaufvorrichtung besteht in bekannter Weise zunächst aus einem Verdichter 1 zur Kompression eines Kältemittels, wobei - jeweils in Strömungsrichtung des Kältemittels gesehen - dem Verdichter 1 ein Kondensator 2, dem Kondensator 2 eine erste Expansionseinrichtung 3, der ersten Expansionseinrichtung 3 ein Wärmeübertrager 4, dem Wärmeübertrager 4 eine zweite Expansionseinrichtung 5, der zweiten Expansionseinrichtung 5 ein Verdampfer 6 und dem Verdampfer 6 im weiteren Verlauf der Verdichter 1 nachgeschaltet ist, wobei der Wärmeübertrager 4, vorzugsweise dessen Primärseite 4.1, mit einer zu kühlenden, elektronischen Einrichtung 7 verbunden ausgebildet ist.

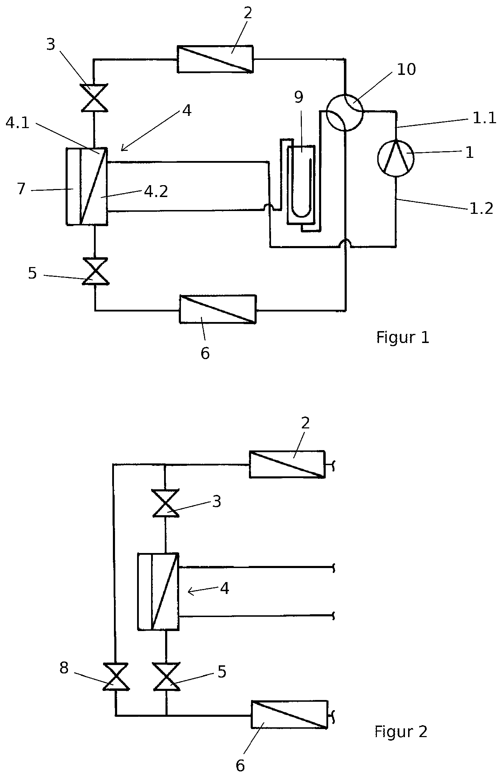

Wie aus Figur 1 ersichtlich, ist dabei besonders bevorzugt vorgesehen, dass zur Umschaltung zwischen einem Heiz- und einem Kühlbetrieb (also zwei Betriebsarten, in denen die Kältekreislaufvorrichtung betreibbar ist) ein sowohl mit einer Druckseite 1.1 als auch mit einer Saugseite 1.2 des Verdichters 1 verbundenes Umschaltventil 10, vorzugsweise ein 4-2-Wegeventil, vorgesehen ist. Bei der in Figur 1 dargestellten Schaltstellung des Umschaltventils 10, die nachfolgend Betriebsart I genannt wird, ist dabei, wie oben angegeben, dem Kondensator das Bezugszeichen 2 und dem Verdampfer das Bezugszeichen 6 zugeordnet. Nach Umschaltung des Schaltventils 10 (nachfolgend Betriebsart II genannt) wird der Wärmeübertrager mit dem Bezugszeichen 6 dann zum Kondensator und entsprechend der Wärmeübertrager mit dem Bezugszeichen 2 zum Verdampfer.

Ob man die Betriebsart I als Heiz- oder Kühlbetrieb bezeichnet, hängt dabei letztlich nur davon ab, in welche Richtung der Wärmetransport erfolgt bzw. erfolgen soll. Nachfolgend wird der Einfachheit halber - und was auch aufgrund des symmetrischen Aufbaus der erfindungsgemäßen Kältekreislaufvorrichtung möglich ist - die Betriebsart I mit dem Heizbetrieb und die Betriebsart II mit dem Kühlbetrieb gleich gesetzt.

Wesentlich für die erfindungsgemäße Kältekreislaufvorrichtung ist nun, und dies gilt für alle dargestellten und vorstellbaren Ausführungsformen, dass der Wärmeübertrager 4 zur zusätzlichen Übertragung von Wärme auf das Kältemittel als innerer Wärmeübertrager ausgebildet ist und eine einerseits mit der ersten und andererseits mit der zweiten Expansionseinrichtung 3, 5 verbundene Primärseite 4.1 und eine einerseits mit dem Verdampfer 6 und andererseits mit dem Verdichter 1 verbundene Sekundärseite 4.2 aufweist. Ganz besonders bevorzugt ist dabei vorgesehen, dass der Wärmeübertrager 4 als Plattenwärmeübertrager ausgebildet ist (siehe hierzu auch https://de.wikipe-dia.org/w/index.php?title=Plattenw%C3%A4rme%C3%BCbertrager&ol-did=199812395), wobei die (verhältnismäßig warme) Primärseite 4.1 des Wärmeübertragers 4 zur Vermeidung einer Kondensatwasserbildung von außenliegenden Kanälen des Plattenwärmeübertragers gebildet ist; und die Sekundärseite 4.2 somit innenliegend angeordnet ist. Oder in anderen Worten: Beim Wärmeübertrager 4 ist die "warme Seite" außen.

Verfahrensmäßig ausgedrückt, ist entsprechend vorgesehen, dass wahlweise mittels der ersten und/oder zweiten Expansionseinrichtung 3, 5 die Temperatur der elektronischen Einrichtung 7 geregelt wird.

Wie aus den Figuren ersichtlich, gibt es verschiedene Möglichkeiten, diese Maßgaben praktisch umzusetzen.

Bei der Lösung gemäß Figur 1 ist bevorzugt vorgesehen, dass die erste und zweite Expansionseinrichtung 3, 5 regelbar ausgebildet sind.

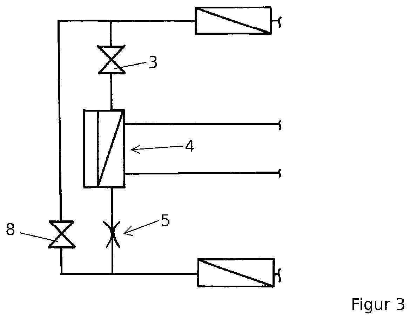

Bei den Lösungen gemäß den Figuren 2 und 3 ist bevorzugt vorgesehen, dass parallel zum Wärmeübertrager 4 und zwischen dem Kondensator 2 und dem Verdampfer 6 eine (vorzugsweise ebenfalls regelbar ausgebildete) Zusatz-Expansionseinrichtung 8 angeordnet ist. Bei der Lösung gemäß Figur 2 sind dabei alle Expansionseinrichtungen 3, 5 und 8 regelbar, bei der Lösung gemäß Figur 3 die Expansionseinrichtungen 3 und 8. Die zweite Expansionseinrichtung 5 ist unregelbar bzw. feststehend ausgebildet. Alternativ kann aber auch vorgesehen sein (was nicht extra dargestellt ist), dass die Expansionseinrichtungen 5 und 8 regelbar und die Expansionseinrichtung 3 unregelbar ausgebildet sind. Oder nochmals in anderen Worten: Es ist bevorzugt vorgesehen, dass die Zusatz-Expansionseinrichtung 8 regelbar und wahlweise die erste oder zweite Expansionseinrichtung 3, 5 unregelbar bzw. feststehend ausgebildet sind. Oder verfahrensmäßig ausgedrückt: Es ist bevorzugt vorgesehen, dass wahlweise mittels der ersten oder der zweiten Expansionseinrichtung 3, 5 und mittels einer parallel zum Wärmeübertrager 4 und zwischen dem Kondensator 2 und dem Verdampfer 6 angeordneten Zusatz-Expansionseinrichtung 8 die Temperatur der elektronischen Einrichtung 7 geregelt wird.

Weiter mit Verweis auf Figur 1, wobei dies aber auch für die Ausführungsformen gemäß Figur 2 und 3 gelten kann, ist weiterhin bevorzugt vorgesehen, dass bei der gewählten Schaltstellung (Betriebsart I) des Umschaltventils 10 und in Strömungsrichtung des Kältemittels gesehen zwischen dem Verdampfer 6 und der Sekundärseite 4.2 des inneren Wärmeübertragers 4 ein Flüssigkeitsabscheider 9 angeordnet ist. Verfahrensmäßig ausgedrückt, ist entsprechend bevorzugt vorgesehen, dass das am Verdampfer 6 verdampfte Kältemittel zunächst einem Flüssigkeitsabscheider 9 und anschließend der Sekundärseite 4.2 des inneren Wärmeübertragers 4 zugeführt wird. Von der anderen Betriebsart, also Betriebsart II, ausgehend, ist der Flüssigkeitsabscheider 9 dann natürlich zwischen dem als Verdampfer arbeitenden Wärmeübertrager 2 und der Sekundärseite 4.2 des inneren Wärmeübertragers 4 angeordnet.

Wie aus Figur 1 ersichtlich, besteht ein solcher Flüssigkeitsabscheider dabei aus einem Behälter, der an seinem unteren Ende mit dem Verdampfer 6 (bzw. in Betriebsart II entsprechend mit dem Kondensator) verbunden ausgebildet ist. Ferner ist ein u-förmig gebogenes Rohr vorgesehen, dass an seinem einen freien Ende und an seinem tiefsten Punkt eine Öffnung aufweist. Mit seinem anderen freien Ende ist es mit der Sekundärseite 4.2 des inneren Wärmeübertragers 4 verbunden. Über die Öffnung am freien Ende wird Kältemitteldampf angesaugt. Die Öffnung am tiefsten Punkt dient dazu, im Behälter abgesetztes Gemisch aus Kältemittel und Öl abzusaugen und dem Verdichter zur Schmierung zuzuführen.

Nach einer anderen, nicht extra dargestellten Ausführungsform ist im übrigen bevorzugt vorgesehen, dass das Kältemittel einem zwischen dem Verdichter 1 und der ersten Expansionseinrichtung 3 angeordneten Flüssigkeitsabscheider 9 zugeführt wird, sprich auf der sogenannten Hochdruckseite des Kältekreislaufs angeordnet ist.

Weiterhin ist bevorzugt vorgesehen, dass im Heizbetrieb wahlweise die erste Expansionseinrichtung 3 und/oder die zweite Expansionseinrichtung 5 auf eine Sauggasüberhitzung von 5 bis 15 K geregelt werden bzw. wird. Hierdurch ist gewährleistet, dass der Taupunkt an der elektronischen Einrichtung und die Mindestöltemperatur nicht unterschritten werden und dass gleichzeitig auch die Ölsumpftemperatur nicht überschritten wird.

Noch etwas genauer betrachtet, ist dabei sogar besonders bevorzugt vorgesehen, dass insbesondere im Heizbetrieb zur Sauggastemperaturregelung wahlweise die erste Expansionseinrichtung 3 und/oder die zweite Expansionseinrichtung 5 in Abhängigkeit von einer Drehzahl des Verdichters 1 geregelt wird.

Bezüglich dieser Drehzahlabhängigkeit ist dabei besonders bevorzugt vorgesehen, dass bei einer niedrigen Drehzahl des Verdichters 1 im Heizbetrieb wahlweise die erste Expansionseinrichtung 3 und/oder die zweite Expansionseinrichtung 5 auf eine Sauggasüberhitzung von 10 bis 15 K geregelt werden. Bei einer höheren Drehzahl des Verdichters 1 im Heizbetrieb ist alternativ bevorzugt vorgesehen, dass wahlweise die erste Expansionseinrichtung 3 und/oder die zweite Expansionseinrichtung 5 auf eine Sauggasüberhitzung von 5 bis 10 K geregelt werden.

Schließlich ist bevorzugt vorgesehen, dass zur Vermeidung einer Taupunktunterschreitung oder Kondenswasserbildung im Kühlbetrieb, bei dem die maximale Ölsumpftemperatur nicht überschritten werden kann, für eine maximale Sauggasüberhitzung die dem Wärmeübertrager 4 in Strömungsrichtung des Kältemittels gesehen vorgeschaltete Expansionseinrichtung 5 (siehe Figur 1) bzw. 8 (siehe Figur 3) vollständig geöffnet wird. Die Ausführungsform gemäß Figur 2 ist für den Kühlbetrieb eher ungeeignet; bei der Ausführungsform gemäß Figur 3 ist die zwischen dem Wärmeübertrager 4 und dem dann als Verdampfer arbeitenden Wärmeübertrager angeordnete Expansionseinrichtung 3 fast vollständig geschlossen.

Der Vollständigkeit halber wird abschließend noch die Funktionsweise der in Figur 1 dargestellten Kältekreislaufvorrichtung in beiden Betriebsarten erläutert (abgesehen von der Zusatz-Expansionseinrichtung 8 gilt dies entsprechend für die Ausführungsformen gemäß Figur 2 und 3):
Wie bereits erläutert, zeigt Figur 1 die Betriebsart I, bei der der mit dem Bezugszeichen 2 versehenen Wärmeübertrager als Kondensator arbeitet. Bei dieser Betriebsart wird das Kältemittel mit dem Verdichter 1 zunächst komprimiert und zu einem ersten Strömungspfad des Umschaltventils 10 und dann zum Kondensator 2 gefördert. Dort angekommen, kondensiert das Kältemittel und gibt dabei Wärme ab. Anschließend gelangt es zur ersten Expansionseinrichtung 3, um dort auf einen niedrigeren Druck gedrosselt zu werden. Am Wärmeübertrager 4 wird dann einerseits Wärme von der elektronischen Einrichtung 7 auf das von der ersten Expansionseinrichtung 3 kommende, durch die Primärseite 4.1 des Wärmeübertragers 4 strömende Kältemittel übertragen. Andererseits wird gleichzeitig Wärme von der Primärseite 4.1 des Wärmeübertragers 4 auf dessen Sekundärseite 4.2 übertragen, worauf weiter unten noch genauer eingegangen wird. Nach der Primärseite 4.1 gelangt das Kältemittel dann in die zweite Expansionseinrichtung 5, wo es nochmals auf einen noch niedrigeren Druck gedrosselt wird. Danach gelangt das Kältemittel dann zum Verdampfer 6, wo ihm Wärme zugeführt wird, so dass es jedenfalls teilweise verdampft. Nach dem Verdampfer 6 gelangt das Kältemittel dann zum zweiten Strömungspfad des Umschaltventils 10 und von dort zum oben bereits genauer beschriebenen Flüssigkeitsabscheider 9. Von dort gelangt das im wesentlichen dampfförmige Kältemittel zur Sekundärseite 4.2 des Wärmeübertragers 4, um dort, wie oben bereits erwähnt, Wärme von der Primärseite 4.1 des Wärmeübertragers 4 aufzunehmen, was dann je nach Stellung der Expansionsventile 3, 5 eine vorteilhafte Sauggasüberhitzung des anschließend zum Verdichter 1 strömenden Kältemittels nach sich sieht.

Wird nur das Umschaltventil 10 auf die andere Betriebsart (hier Kühlbetrieb) umgeschaltet, strömt das Kältemittel nach dem Verdichter 1 am Umschaltventil 10 entsprechend nicht mehr zum Wärmeübertrager (vormals Kondensator) 2, sondern direkt zum Wärmeübertrager 6, der nunmehr als Kondensator arbeitet, wobei die zweite Expansionseinrichtung 5, die Primärseite 4.1 des Wärmeübertragers 4, die erste Expansionseinrichtung 3 und der Wärmeübertrager mit dem Bezugszeichen 2, der dann als Verdampfer arbeitet, dann entsprechend in umgekehrter Richtung durchströmt werden, bis das Kältemittel dann wiederum zum Umschaltventil 10 gelangt und von dort auch wieder zum Flüssigkeitsabscheider 9 geleitet wird, um anschließend nach Passage der Sekundärseite 4.2 des Wärmeübertragers 4 ebenfalls wieder zum Verdichter zu gelangen.

### Bezugszeichenliste

- 1: Verdichter
- 1.1: Druckseite
- 1.2: Saugseite
- 2: Kondensator
- 3: erste Expansionseinrichtung
- 4: innerer Wärmeübertrager
- 4.1: Primärseite des inneren Wärmeübertragers
- 4.2: Sekundärseite des inneren Wärmeübertragers
- 5: zweite Expansionseinrichtung
- 6: Verdampfer
- 7: elektronische Einrichtung
- 8: Zusatz-Expansionseinrichtung
- 9: Flüssigkeitsabscheider
- 10: Umschaltventil

## Patentansprüche

1. Kältekreislaufvorrichtung, umfassend eine elektronische Einrichtung (7) und einen Verdichter (1) zur Kompression eines Kältemittels, wobei - jeweils in Strömungsrichtung des Kältemittels gesehen - dem Verdichter (1) ein Kondensator (2), dem Kondensator (2) eine erste Expansionseinrichtung (3), der ersten Expansionseinrichtung (3) ein Wärmeübertrager (4), dem Wärmeübertrager (4) eine zweite Expansionseinrichtung (5), der zweiten Expansionseinrichtung (5) ein Verdampfer (6) und dem Verdampfer (6) im weiteren Verlauf der Verdichter (1) nachgeschaltet ist, wobei der Wärmeübertrager (4) zur zusätzlichen Übertragung von Wärme auf das Kältemittel als innerer Wärmeübertrager ausgebildet ist und eine einerseits mit der ersten und andererseits mit der zweiten Expansionseinrichtung (3, 5) verbundene Primärseite (4.1) und eine einerseits mit dem Verdampfer (6) und andererseits mit dem Verdichter (1) verbundene Sekundärseite (4.2) aufweist, **dadurch gekennzeichnet, dass** der Wärmeübertrager (4) mit der zu kühlenden, elektronischen Einrichtung (7) verbunden ausgebildet ist.

2. Kältekreislaufvorrichtung nach Anspruch 1,
**dadurch gekennzeichnet,**
**dass** die erste und zweite Expansionseinrichtung (3, 5) regelbar ausgebildet sind.

3. Kältekreislaufvorrichtung nach Anspruch 1 oder 2,
**dadurch gekennzeichnet,**
**dass** parallel zum Wärmeübertrager (4) und zwischen dem Kondensator (2) und dem Verdampfer (6) eine Zusatz-Expansionseinrichtung (8) angeordnet ist.

4. Kältekreislaufvorrichtung nach Anspruch 3,
**dadurch gekennzeichnet,**
**dass** die Zusatz-Expansionseinrichtung (8) regelbar ausgebildet ist.

5. Kältekreislaufvorrichtung nach Anspruch 1 und 3,
**dadurch gekennzeichnet,**
**dass** die Zusatz-Expansionseinrichtung (8) regelbar und wahlweise die erste oder zweite Expansionseinrichtung (3, 5) unregelbar ausgebildet sind.

6. Kältekreislaufvorrichtung nach einem der Ansprüche 1 bis 5, **dadurch gekennzeichnet,**
**dass** der Wärmeübertrager (4) als Plattenwärmeübertrager ausgebildet ist.

7. Verfahren zum Betrieb einer Kältekreislaufvorrichtung gemäß dem Patentanspruch 1,
**dadurch gekennzeichnet,**
**dass** wahlweise mittels der ersten und/oder zweiten Expansionseinrichtung (3, 5) die Temperatur der elektronischen Einrichtung (7) geregelt wird.

8. Verfahren nach Anspruch 7,
**dadurch gekennzeichnet,**
**dass** wahlweise mittels der ersten oder der zweiten Expansionseinrichtung (3, 5) und mittels einer parallel zum Wärmeübertrager (4) und zwischen dem Kondensator (2) und dem Verdampfer (6) angeordneten Zusatz-Expansionseinrichtung (8) die Temperatur der elektronischen Einrichtung (7) geregelt wird.

9. Verfahren nach Anspruch 7 oder 8,
**dadurch gekennzeichnet,**
**dass** die Kältekreislaufvorrichtung wahlweise im Heiz- oder Kühlbetrieb betrieben wird.

10. Verfahren nach Anspruch 9,
**dadurch gekennzeichnet,**
**dass** im Kühlbetrieb für eine maximale Sauggasüberhitzung die Expansionseinrichtung (5, 8) vollständig geöffnet wird.

11. Verfahren nach Anspruch 9,
**dadurch gekennzeichnet,**
**dass** im Heizbetrieb wahlweise die erste Expansionseinrichtung (3) und/oder die zweite Expansionseinrichtung (5) auf eine Sauggasüberhitzung von 5 bis 15 K geregelt werden bzw. wird.

## Claims

1. A refrigeration circuit device, comprising an electronic device (7) and a compressor (1) for compressing a refrigerant, wherein - in each case as viewed in the flow direction of the refrigerant - a condenser (2) is connected downstream of the compressor (1), a first expansion device (3) is connected downstream of the condenser (2), a heat exchanger (4) is connected downstream of the first expansion device (3), a second expansion device (5) is connected downstream of the heat exchanger (4), an evaporator (6) is connected downstream of the second expansion device (5) and the compressor (1) is later connected downstream of the evaporator (6), wherein the heat exchanger (4) is configured as an internal heat exchanger for the additional transfer of heat to the refrigerant, and comprises a primary side (4.1) which is connected on the one hand to the first expansion device (3) and on the other hand to the second expansion device (5), and a secondary side (4.2) which is connected on the one hand to the evaporator (6) and on the other hand to the compressor (1),
**characterized in that**
the heat exchanger (4) is configured so as to be connected to the electronic device (7) that is to be cooled.

2. The refrigeration circuit device according to claim 1, **characterized in that**
the first and second expansion devices (3, 5) are configured to be controllable.

3. The refrigeration circuit device according to claim 1 or 2,
**characterized in that**
an additional expansion device (8) is arranged parallel to the heat exchanger (4) and between the condenser (2) and the evaporator (6).

4. The refrigeration circuit device according to claim 3, **characterized in that**
the additional expansion device (8) is configured to be controllable.

5. The refrigeration circuit device according to claim 1 and 3,
**characterized in that**
the additional expansion device (8) is configured to be controllable and selectively the first or second expansion device (3, 5) are configured to be uncontrollable.

6. The refrigeration circuit device according to one of claims 1 to 5,
**characterized in that**
the heat exchanger (4) is configured as a plate heat exchanger.

7. A method for operating a refrigeration circuit device according to claim 1,
**characterized in that**
the temperature of the electronic device (7) is selectively controlled with the aid of the first and/or second expansion device (3, 5).

8. The method according to claim 7,
**characterized in that**
the temperature of the electronic device (7) is selectively controlled with the aid of the first or the second expansion device (3, 5) and with the aid of an additional expansion device (8) arranged parallel to the heat exchanger (4) and between the condenser (2) and the evaporator (6).

9. The method according to claim 7 or 8,
**characterized in that**
the refrigeration circuit device is selectively operated in heating mode or cooling mode.

10. The method according to claim 9,
**characterized in that**
in cooling mode, the expansion device (5, 8) is fully opened for maximum suction gas superheat.

11. The method according to claim 9,
**characterized in that**
in heating mode, the first expansion device (3) and/or the second expansion device (5) are selectively controlled for a suction gas superheat of 5 to 15 K.

## Revendications

1. Dispositif de circuit de refroidissement, comprenant une installation (7) électronique et un compresseur (1) pour la compression d'un agent réfrigérant, (considérés chaque fois dans la direction d'écoulement de l'agent réfrigérant) un condensateur (2) étant monté en aval du compresseur (1), un premier système d'expansion (3) étant monté en aval du condensateur (2), un échangeur thermique (4) étant monté en aval du premier système d'expansion (3), un deuxième système d'expansion (5) étant monté en aval de l'échangeur thermique (4), un évaporateur (6) étant monté en aval du deuxième système d'expansion (5) et dans la suite du trajet, le compresseur (1) étant monté en aval de l'évaporateur (6), pour un transfert additionnel de chaleur sur l'agent réfrigérant, l'échangeur thermique (4) étant conçu sous la forme d'un échangeur thermique interne et comportant un côté primaire (4.1), relié d'une part avec le premier et d'autre part avec le deuxième système d'expansion (3, 5) et un côté secondaire (4.2), relié d'une part avec l'évaporateur (6) et d'autre part avec le compresseur (1),
**caractérisé**
**en ce que** l'échangeur thermique (4) est conçu en étant relié avec l'installation (7) électronique qu'il s'agit de refroidir.

2. Dispositif de circuit de refroidissement selon la revendication 1,
**caractérisé**
**en ce que** le premier et le deuxième systèmes d'expansion (3, 5) sont conçus en étant réglables.

3. Dispositif de circuit de refroidissement selon la revendication 1 ou 2,
**caractérisé**
**en ce qu'**à la parallèle de l'échangeur thermique (4) et entre le condensateur (2) et l'évaporateur (6) est placé un système d'expansion additionnel (8).

4. Dispositif de circuit de refroidissement selon la revendication 3,
**caractérisé**
**en ce que** le système d'expansion additionnel (8) est conçu en étant réglable.

5. Dispositif de circuit de refroidissement selon la revendication 1 et 3,
**caractérisé**
**en ce que** le système d'expansion additionnel (8) est conçu en étant réglable et sélectivement le premier ou le deuxième système d'expansion (3, 5) sont conçus en n'étant pas réglables.

6. Dispositif de circuit de refroidissement selon l'une quelconque des revendications 1 à 5,
**caractérisé**
**en ce que** l'échangeur thermique (4) est conçu sous la forme d'un échangeur thermique à plaques.

7. Procédé opérationnel d'un dispositif de circuit de refroidissement selon la revendication 1 du brevet,
**caractérisé**
**en ce que** la température de l'installation (7) électronique est réglée sélectivement au moyen du premier et / ou du deuxième système d'expansion (3, 5).

8. Procédé selon la revendication 7,
**caractérisé**
**en ce que** la température de l'installation (7) électronique est réglée sélectivement au moyen du premier ou du deuxième système d'expansion (3, 5) et au moyen d'un système d'expansion additionnel (8), placé à la parallèle de l'échangeur thermique (4) et entre le condensateur (2) et l'évaporateur (6).

9. Procédé selon la revendication 7 ou 8,
**caractérisé**
**en ce que** l'on fait fonctionner le dispositif de circuit de refroidissement sélectivement en mode chauffage ou en mode refroidissement.

10. Procédé selon la revendication 9,
**caractérisé**
**en ce qu'**en mode refroidissement, le système d'expansion (5, 8) est ouvert totalement, pour une surchauffe maximale du gaz d'aspiration.

11. Procédé selon la revendication 9,
**caractérisé**
**en ce qu'**en mode chauffage, sélectivement, le premier système d'expansion (3) et / ou le deuxième système d'expansion (5) sont ou est réglé(s) à une surchauffe du gaz d'aspiration de 5 à 15 K.
